**Europäisches Patentamt**

**European Patent Office**

**Office européen des brevets**

(19)

(11) Publication number : **0 361 721 B1**

## (12) EUROPEAN PATENT SPECIFICATION

(45) Date of publication of patent specification :
17.03.93 Bulletin 93/11

(51) Int. Cl.[5] : **C04B 35/00, H01B 3/12**

(21) Application number : **89309190.0**

(22) Date of filing : **11.09.89**

(54) Dielectric ceramic composition.

(30) Priority : **30.09.88 JP 247058/88**

(43) Date of publication of application :
**04.04.90 Bulletin 90/14**

(45) Publication of the grant of the patent :
**17.03.93 Bulletin 93/11**

(84) Designated Contracting States :
**DE FR GB**

(56) References cited :
**EP-A- 0 252 668**
**EP-A- 0 321 243**
**CHEMICAL ABSTRACTS, vol. 103, no. 12, September 1985, page 647, abstract no. 97547q, Columbus, Ohio, US; & JP-A-60 68 503 (UBE INDUSTRIES LTD) 19-04-1985**
**CHEMICAL ABSTRACTS, vol. 108, no. 20, May 1988, abstract no. 178507g, Columbus, Ohio, US; & JP-A-62 157 608 (MURATA MFG CO., LTD) 13-07-1987**

(73) Proprietor : **SUMITOMO METAL MINING COMPANY LIMITED**
**11-3, Shinbashi 5-chome Minato-ku**
**Tokyo 105 (JP)**

(72) Inventor : **Matsumoto, Kazutoshi**
**267 Shimoyagiri**
**Matsudo City Chiba Prefecture (JP)**
Inventor : **Hyuga, Takehiro**
**3-18-35, Nakakokubun**
**Ichikawa City Chiba Prefecture (JP)**
Inventor : **Mukai, Tetsuya**
**4-16, Tokiwadaira**
**Matsudo City Chiba Prefecture (JP)**

(74) Representative : **Wilson, Nicholas Martin et al**
**WITHERS & ROGERS 4 Dyer's Buildings Holborn**
**London EC1N 2JT (GB)**

## Description

The present invention concerns a dielectric ceramic composition of high dielectric constant and high quality factor under unload state and also having stable temperature characteristics.

Generally, dielectric ceramic materials of high dielectric constant and high quality factor under unload state and also having stable temperature characteristic have been used for dielectric resonators or dielectric substrates used in signal circuits for high frequency regions such as microwave or milliwave bands.

As the dielectric ceramic material of this kind there have been proposed, for example, Ba(Zn.Ta)O series (Japanese Patent Publication Sho 59-48484), Ba(Zn.Nb)O series (Japanese Patent Publication Sho 59-48484), Ba(Zn.Ta.Nb)O series (Japanese Patent Publication Sho 59-23044) or Ba(Mg.Ni.Ta)O series (Japanese Patent Laid-Open Sho 60-210407) and Ba(Mg.Co.Ta)O series (Japanese Patent Laid-Open Sho 61-8804).

However, although the dielectric ceramic material comprising the compositions in the former group of three patent publications have high dielectric constant as from 30 to 40, quality factor used unload state is as low as about 5,000 in a high frequency band of about 10 GHz. On the other hand, the dielectric ceramic materials comprising the compositions of the latter group of two patent laid-publication have high quality factors under unload state (hereinafter referred to as unloaded Q) such as about 8,000 in the high frequency band of about 10 GHz, but the dielectric constant is as low as about 25. Accordingly, there has been a problem that none of them can satisfy the requirement desired to dielectric ceramic material of having higher unloaded Q and greater dielectric constant along with increase in the performance of the communication equipments in recent years.

Accordingly, it is an object of the present invention to provide a dielectric ceramic composition capable of overcoming the foregoing problems and having high unloaded Q and high dielectric constant even in a high frequency band of 10 GHz and also having stable temperature characteristic.

The present inventors have made earnest studies for overcoming the foregoing problems and attaining the foregoing object and, as a result, have accomplished the present invention based on the finding that the object can be attained by an oxide composition containing Ba, Zn, Mg, Ni, Ta, Nb or Co each at a predetermined ratio.

That is, the first feature of the present invention resides in a dielectric ceramic composition comprising oxides containing Ba, Zn, Mg, Ni and Ta each within such a range that BaO is not less than 59.5 mol% and not greater than 61.5%, ZnO is less than 10 mol%, MgO is less than 10 mol%, NiO less than 20 mol% and $Ta_2O_5$ is not less than 19.3 mol% and less than 21 mol%.

A portion of Ni may be substituted with less than 0.4 mol% of Co as CoO.

In both of the dielectric ceramic compositions, $Ta_2O_5$ is substituted by $Nb_2O_5$ to an extent no greater than 95 mol%.

For each of the ingredients in the present invention, oxide powder at a purity of about 99.9 wt% is preferably used. If BaO is less than 59.5 mol% or exceeds 61.5 mol%, unloaded Q is reduced. If ZnO exceeds 10 mol%, unloaded Q is reduced and, if it is 0 mol%, the dielectric constant is reduced or unloaded Q is reduced. If MgO exceeds 10 mol%, the dielectric constant is reduced and, if it is 0 mol%, the unloaded Q is reduced. If NiO exceeds 20 mol%, the unloaded Q is reduced and if it is 0 mol%, the temperature coefficient of the resonant frequency is increased excessively in the positive level. If $Ta_2O_5$ is out of the range of not less than 19.3 mol% and less than 21 mol%, unloaded Q is reduced. If $Ta_2O_5$ is replaced or substituted with $Nb_2O_{25}$ in an amount of exceeding 95 mol%, unloaded Q is reduced and the temperature coefficient for the resonant frequency is positively increased excessively. Accordingly, it is preferred to substitute $Ta_2O_5$ with $Nb_2O_5$ in a proportion below 95 mol%. Further, if Ni is partially substituted with Co, the sintering temperature can be lowered by from 20 to 50°C with no remarkable degradation in the unloaded Q. However, if CoO exceeds 0.4 mol%, unloaded Q is reduced to lower the mechanical strength of the ceramic material tending to cause chipping, etc.

Aimed products can be obtained from the starting powder blended in such a ratio by wet-mixing together with purified water for 10 to 20 hours in a pot made of resin using resin-coated balls, drying at 100 - 150°C for 1 - 3 hours, calcining in oxygen or atmosphere at 1000 - 1300°C for 1 - 5 hours, pulverizing the calcinating products to about 400 - 150 μm (40-100 mesh), press-moulding, for example, by a hydrostatic press under the pressure of 49-196MPa (500-2000 kg/cm²), preferably 98-196MPa (1000-2000 kg/cm²) and then sintering the press-moulding product in oxygen or atmosphere at 1450 - 1650°C for 2 - 10 hours.

## EXAMPLES

The present invention is to be explained referring to examples.

Examples 1-3, 5-6, 8-9

Powders of barium carbonate, zinc oxide, magnesium oxide, nickel oxide, tantalum oxide and niobium oxide each at 99.9 wt% purity as starting material were weighted such that the composition of the dielectric ceramic materials as final products provide various compositions as shown in Table 1. The weighted starting material powder was placed together with purified water into a resin post and then mixed by using resincoated balls for 16 hours in a wet process. Then, they were calcinated in oxygen at 1000 - 1200°C for 2 hours. The calcinating products were pulverized and arranged passing through a 375 μm (42 mesh) sieve and the resultant powder was subjected to primary moulding into a disc of 10 cm diameter and 5 mm thickness by using a moulding die under the pressure of 49MPa (500 kg/cm$^2$). Then, the moulding product was sintered in oxygen at 1500 - 1650°C for 4 hours, to obtain dielectric ceramic material.

The dielectric constant ($\epsilon_\tau$), unloaded Q ($Q_0$) and the temperature coefficient for the resonant frequency ($\tau f$) of the resultant dielectric ceramic material were measured by using a dielectric cylinder resonator method under the frequency of about 10 GHz. The results are shown in Table 1.

Comparative Examples 1 - 10

Dielectric ceramic materials of compositions shown in the Table 2 were prepared in the same procedures as those in examples and various tests were conducted in the same way as in the examples. The results are shown in Table 1.

Table 1

| | No. | Composition (mol %) Ba | Zn | Mg | Ni | Ta | Substituted Nb in Ta | Dielectric constant ($\varepsilon_r$) | Unloaded Q ($Q_o$) | Temperature coefficient $\tau_f$ (ppm/°C) |
|---|---|---|---|---|---|---|---|---|---|---|
| Example | 1 | 60.0 | 0.5 | 0.5 | 19.0 | 20.0 | 70.0 | 31.7 | 8800 | -0.9 |
| Example | 2 | 60.0 | 0.5 | 9.5 | 10.0 | 20.0 | 90.0 | 32.6 | 10800 | 9.9 |
| Example | 3 | 61.5 | 2.4 | 2.4 | 14.4 | 19.3 | 80.0 | 34.1 | 9700 | 4.9 |
| Example | 5 | 60.0 | 5.0 | 5.0 | 10.0 | 20.0 | 0.0 | 25.4 | 16700 | -7.0 |
| Example | 6 | 60.0 | 7.5 | 2.5 | 10.0 | 20.0 | 40.0 | 29.9 | 14500 | 2.1 |
| Example | 8 | 61.0 | 9.2 | 9.2 | 1.0 | 19.6 | 10.0 | 27.1 | 23000 | 3.5 |
| Example | 9 | 60.5 | 9.4 | 1.0 | 9.4 | 19.7 | 30.0 | 29.5 | 14000 | 0.1 |
| Comparative Example | 1 | 60.0 | 0.0 | 0.0 | 20.0 | 20.0 | 80.0 | 32.8 | 6900 | 0.2 |
| Comparative Example | 2 | 61.0 | 0.0 | 4.9 | 14.6 | 19.5 | 60.0 | 27.7 | 7900 | 1.1 |
| Comparative Example | 3 | 60.0 | 2.5 | 7.5 | 10.0 | 20.0 | 100.0 | 32.8 | 7200 | 18.2 |
| Comparative Example | 4 | 58.0 | 2.6 | 2.6 | 15.8 | 21.0 | 80.0 | 31.4 | 7900 | 10.1 |
| Comparative Example | 5 | 60.0 | 5.0 | 0.0 | 15.0 | 20.0 | 60.0 | 31.0 | 7900 | 1.0 |
| Comparative Example | 6 | 59.5 | 5.1 | 10.1 | 5.1 | 20.2 | 0.0 | 24.9 | 7500 | -3.0 |
| Comparative Example | 7 | 62.0 | 9.0 | 9.0 | 1.0 | 19.0 | 70.0 | 36.3 | 7100 | 20.4 |
| Comparative Example | 8 | 60.0 | 9.5 | 9.5 | 1.0 | 20.0 | 100.0 | 36.4 | 9500 | 29.1 |
| Comparative Example | 9 | 60.0 | 10.0 | 5.0 | 5.0 | 20.0 | 80.0 | 34.8 | 8000 | 19.3 |
| Comparative Example | 10 | 60.0 | 10.0 | 10.0 | 0.0 | 20.0 | 90.0 | 35.3 | 8100 | 27.6 |

Examples 10, 12-14, 16

Aimed products were obtained by the same procedures as those in each of the examples described above excepting that powders for barium carbonate, zinc, oxide, magnesium oxide, nickel, oxide, cobalt oxide, tantalum oxide and niobium oxide each at a purity of 99.9 wt% as the starting material were weighted such that the composition of the dielectric ceramic material as the aimed products provide various compositions as shown in Table 2 and the range for the sintering temperature of the moulding product was controlled to 1450 - 1650°C. Various tests were conducted in the same way as in the examples. Results as shown in Table 2.

Comparative Examples 11 - 12

In the same procedures as those in Examples 10, 12-14, 16, dielectric ceramic materials of the compositions as shown in Table 2 were prepared and various tests were conducted in the same way as in Examples 1 - 9. The results are shown in Table 2.

Table 2

EP 0 361 721 B1

| | | Composition mol % | | | | | | Substituted Nb in Ta | Sintering temperature (°C) | Dielectric constant ($\epsilon_r$) | Unloaded Q ($Q_o$) | Temperature coefficient $\tau_f$ (ppm/°C) | Remarks |
|---|---|---|---|---|---|---|---|---|---|---|---|---|---|
| | No. | Ba | Zn | Mg | Ni | Co | Ta | | | | | | |
| Example | 10 | 61.5 | 2.3 | 2.3 | 14.6 | 0 | 19.3 | 80 | 1500 | 33.8 | 11000 | 4 | |
| | | | | | | | | | | | | | |
| | 12 | 60 | 5.3 | 5.3 | 9.4 | 0 | 20 | 0 | 1650 | 25.8 | 17300 | -5.8 | |
| | 13 | 60 | 5.3 | 5.3 | 9.3 | 0.1 | 20 | 0 | 1630 | 25.8 | 15100 | -5.6 | |
| | 14 | 60 | 5.3 | 5.3 | 9.2 | 0.2 | 20 | 0 | 1600 | 25.6 | 14000 | -5.5 | |
| | | | | | | | | | | | | | |
| | 16 | 61.5 | 2.3 | 2.3 | 14.25 | 0.35 | 19.3 | 80 | 1450 | 33.2 | 9900 | 3.7 | |
| Comp. Example | 11 | 61.5 | 2.3 | 2.3 | 14.2 | 0.4 | 19.3 | 80 | 1440 | | | | chipped |
| | 12 | 58.5 | 2.7 | 7.7 | 10 | 0.4 | 20.7 | 60 | 1550 | 29.3 | 7900 | 1.1 | |

6

According to the present invention, since Ba, Zn, Mg, Ni, Ta, Nb, Co, etc..., are contained each at a predetermined ratio, it is possible to obtain dielectric ceramic compositions excellent both in dielectric constant and unload quality factor and also having stable temperature characteristic. In addition, when Ni is partially substituted with Co, the sintering temperature can be lowered with no remarkable reduction in unload quality factor.

## Claims

1. A dielectric ceramic composition comprising oxides containing Ba, Zn, Mg, Ni and Ta each within such a range that BaO is not less than 59.5 mol% and not greater than 61.5 mol%, ZnO is less than 10 mol%, MgO is less than 10 mol%, NiO is less than 20 mol%, $Ta_2O_5$ is not less than 19.3 mol% and less than 21 mol%.

2. A dielectric ceramic composition as defined in claim 1, wherein $Ta_2O_5$ is substituted by $Nb_2O_5$ to an extent not greater than 95 mol%.

3. A dielectric ceramic composition as defined in claim 1, wherein the purity for each of the oxides is about 99.9 wt%.

4. A dielectric ceramic composition according to claim 1, 2 or 3 in which a portion of Ni is substituted with less than 0.4 mol% of Co as CoO.

5. A dielectric ceramic composition as defined in claim 4, wherein $Ta_2O_5$ is substituted by $Nb_2O_5$ to an extent not greater than 95 mol%.

6. A dielectric ceramic composition as defined in claim 4, wherein the purity for each of the oxides is about 99.9 wt%.

## Patentansprüche

1. Dielektrische keramische Zusammensetzung mit Oxiden, die Ba, Zn, Mg, Ni und Ta jeweils innerhalb eines solchen Mengenbereichs enthalten, daß an BaO nicht weniger als 59,5 Molprozent und nicht mehr als 61,5 Molprozent, an ZnO weniger als 10 Molprozent, an MgO weniger als 10 Molprozent, an NiO weniger als 20 Molprozent, an $Ta_2O_5$ nicht weniger als 19,3 Molprozent und weniger als 21 Molprozent vorhanden sind.

2. Dielektrische keramische Zusammensetzung nach Anspruch 1, bei der $Ta_2O_5$ durch $Nb_2O_5$ in einem 95 Molprozent nicht übersteigenden Maße substituiert ist.

3. Dielektrische keramische Zusammensetzung nach Anspruch 1, bei der die Reinheit bei jedem der Oxide ungefähr 99,9 Gewichtsprozent beträgt.

4. Dielektrische keramische Zusammensetzung nach Anspruch 1, 2 oder 3, bei der ein Teil des Ni durch weniger als 0,4 Molprozent Co als CoO substituiert ist.

5. Dielektrische keramische Zusammensetzung nach Anspruch 4, bei der $Ta_2O_5$ durch $Nb_2O_5$ in einem 95 Molprozent nicht übersteigenden Maße substituiert ist.

6. Dielektrische keramische Zusammensetzung nach Anspruch 4, bei der die Reinheit bei jedem der Oxide ungefähr 99,9 Gewichtsprozent beträgt.

## Revendications

1. Composition céramique diélectrique comprenant des oxydes contenant Ba, Zn, Mg, Ni et Ta, chacun présent en une proportion se situant dans une gamme telle que la teneur en BaO n'est pas inférieure à 59,5 moles % et n'est pas supérieure à 61,5 moles %, la teneur en ZnO est inférieure à 10 moles %, la teneur en MgO est inférieure à 10 moles %, la teneur en NiO est inférieure à 20 moles %,la teneur en $Ta_2O_5$ n'est pas inférieure à 19,3 moles % et est inférieure à 21 moles % .

2. Composition céramique diélectrique telle que définie à la revendication 1 ,dans laquelle $Ta_2O_5$ est remplacé par $Nb_2O_5$,en une proportion non supérieure à 95 moles % .

3. Composition céramique diélectrique telle que définie à la revendication 1 , dans laquelle la pureté de chacun des oxydes est d'environ 99,9 % en poids .

4. Composition céramique diélectrique selon la revendication 1 , 2 ou 3 , dans laquelle une partie de Ni est remplacée par moins de 0,4 mole % de Co sous forme de CoO.

5. Composition céramique diélectrique telle que définie à la revendication 4 , dans laquelle $Ta_2O_5$ est remplacé par $Nb_2O_5$ ,en une proportion non supérieure à 95 moles % .

6. Composition céramique diélectrique selon la définition apparaissant à la revendication 4 , dans laquelle la pureté de chacun des oxydes est d'environ 99,9 % en poids .